(19) Europäisches Patentamt

European Patent Office

Office européen des brevets

(11) **EP 1 171 294 B1**

(12) **FASCICULE DE BREVET EUROPEEN**

(45) Date de publication et mention
de la délivrance du brevet:
**23.02.2005 Bulletin 2005/08**

(51) Int Cl.⁷: **B32B 17/10**, H01L 31/048,
C03C 27/12

(21) Numéro de dépôt: **00926911.9**

(22) Date de dépôt: **12.04.2000**

(86) Numéro de dépôt international:
**PCT/EP2000/003332**

(87) Numéro de publication internationale:
**WO 2000/061366 (19.10.2000 Gazette 2000/42)**

(54) **TOIT DE VEHICULE AUTOMOBILE**

KRAFTFAHRZEUGDACH

ROOF OF A MOTOR VEHICLE

(84) Etats contractants désignés:
**AT BE CH CY DE DK ES FI FR GB GR IE IT LI LU
MC NL PT SE**

(30) Priorité: **13.04.1999  BE 9900251
27.09.1999  BE 9900643**

(43) Date de publication de la demande:
**16.01.2002  Bulletin 2002/03**

(73) Titulaire: **Glaverbel
1170 Bruxelles (Watermael-Boitsfort) (BE)**

(72) Inventeurs:
• **COSTER, Dominique
B-5020 Temploux (BE)**
• **GUINDON, Christian
F-75016 Paris (FR)**
• **LEGRAND, Denis
F-59144 Wargnies (FR)**

• **MASEREEL, Alain
F-59710 Mérignies (FR)**
• **BAUDIN, Pol
B-6140 Fontaine l'Evêque (BE)**

(74) Mandataire: **Le Vaguerèse, Sylvain Jacques
Glaverbel
Rue de l'Aurore, 2
6040 Jumet (BE)**

(56) Documents cités:
**FR-A- 2 428 920        US-A- 4 717 790
US-A- 5 213 626        US-A- 5 228 925**

Remarques:
Le dossier contient des informations techniques
présentées postérieurement au dépôt de la
demande et ne figurant pas dans le présent
fascicule.

**Description**

L'invention est relative aux toits de véhicules automobiles comportant une partie assurant une certaine transmission lumineuse dans l'habitacle.

Les constructeurs automobiles développent des modèles dont la surface vitrée est toujours plus importante. Les dimensions des pare-brise et des lunettes arrières sont en progression notamment pour améliorer les profils aérodynamiques. Au delà, les vitrages entrent de façon prépondérante dans la constitution des toits ouvrants. Suivant cette tendance, les constructeurs souhaitent l'utilisation de vitrages formant la totalité , ou au moins une part très importante des toits des véhicules.

L'utilisation de vitrages formant la majeure partie du toit, conduit pour des raisons à la fois d'esthétique, mais aussi pour des raisons techniques telles que l'étanchéité de la structure, la réduction des bruits aérodynamiques, ou la commodité de montage, à limiter le plus possible le nombre de éléments de vitrages constituant le toit. Le cas le plus favorable correspond par exemple à un vitrage unique formant l'ensemble du toit

Les toits dont toute la surface présente les mêmes caractéristiques, notamment de transparence, constituent une part significative de ce que réclament les constructeurs. Les toits de ce type, s'ils doivent offrir une certaine transparence, doivent plus encore prévenir une transmission énergétique trop importante, pour préserver le confort des passagers. Cependant, il reste des dispositions dans lesquelles les toits comportent simultanément plusieurs parties remplissant des fonctions différentes, et qui pour cette raison doivent présenter des caractéristiques différentes. En particulier certaines fonctions peuvent conduire à faire que la partie du vitrage remplissant cette fonction ne soit pas transparente.

L'objet de l'invention est de fournir des toits de véhicules, automobiles vitrés, dont au moins une partie présente une certaine transparence, et dont au moins une autre partie doit satisfaire à des conditions de transmission différentes. Un cas typique de vitrages répondant à cette dernière exigence, est celui des vitrages qui pourvus de cellules photovoltaïques. L'invention est décrite dans la suite à propos de ces vitrages recevant des cellules de ce type. Elle peut s'appliquer cependant à d'autres sortes de vitrages dont seulement une partie doit offrir la transparence indiquée.

Les constructeurs de véhicules automobiles proposent sur certains modèles, en particulier de haut de gamme, l'installation de cellules photovoltaïques qui ont pour fonction de limiter la sollicitation des accumulateurs, notamment lorsque le moteur du véhicule ne fonctionne pas. A l'heure actuelle ceci est utilisé par exemple pour recharger les accumulateurs, ou pour alimenter une ventilation et limiter ainsi l'échauffement du véhicule à l'arrêt. D'autres utilisations sont néanmoins dès à présent envisagées qui toutes ont en commun de constituer une source complémentaire d'énergie pour réduire d'autant la consommation de celle générée par le moteur du véhicule.

Pour une bonne efficacité, il convient de disposer les cellules sur une surface bien exposée aussi vaste que possible, et sous une protection qui les met à l'abri des agressions de l'environnement: humidité, graisse etc. Les cellules sont donc placées derrière un écran transparent, constitué habituellement d'une feuille de verre.

Dans les véhicules commercialisés qui comportent des cellules, l'emplacement de celles-ci s'est orienté vers le toit pour des raisons de commodité. L'adaptation de cellules photovoltaïques sur des éléments de toits en verre a fait l'objet de diverses propositions antérieures.

Le Plus usuellement l'art antérieur propose de disposer les cellules sur un toit ouvrant comme dans US 5,213,626 ou dans US 5,228,925, ou encore dans US 4,717,790. Ces réalisations sont telles que les vitrages concernés ne participent pas de façon significative à la tenue mécanique du toit. En outre les dimensions réduites des pièces concernées, font que les contraintes notamment de transmission énergétique sont ignorées, alors gu'elles constituent un élément important dans les propriétés que doivent présenter les vitrages de toits.

Toujours pour ce qui concerne les véhicules commercialisés comportant ce type d'équipement, la mise en place de cellules photovoltaïques a été faite sur une feuille de verre formant au moins une partie du toit, et sur la face de cette feuille qui n'est pas exposée à l'environnement extérieur. Les cellules sont collées sur la feuille de verre, et protégées et dissimulées du côté de l'habitacle par un parement.

Une difficulté pour la formation de ces toits comportant des cellules, réside dans le fait que, pour satisfaire aux normes de sécurité, notamment en matière de résistance mécanique, la feuille de verre doit présenter une certaine épaisseur. Plus le verre est épais, plus la part de l'énergie transmise aux cellules est réduite.

Typiquement, dans les réalisations antérieures, une feuille de verre trempé d'au moins 5mm d'épaisseur est nécessaire. A ces épaisseurs, les verres clairs usuels ont une absorption qui n'est pas négligeable. La transmission énergétique (TE), mesurée selon Moon, s'établit par exemple aux environs de 82% de la lumière incidente

Ces réalisations antérieures conduisent donc, pour les cellules, à une efficacité qui n'est pas optimisée. Il est souhaitable de rechercher une mise en oeuvre qui réduise au minimum l'absorption sans compromettre les qualités mécaniques.

Dans ce sens, il est possible, tout en gardant la structure décrite ci-dessus, d'utiliser des verres dits "extra clairs". Ces verres qui présentent notamment comme particularité une teneur en fer extrêmement faible, sont relativement peu absorbants. Sous une épaisseur de 5mm, comme précédemment, la TE peut être de l'ordre de 90%, soit un gain de l'ordre de 8%. L'inconvénient de ces verres réside dans leur coût. Leur prix est environ 2,5 fois celui des verres clairs ordinaires. Même si le coût du verre n'entre que pour une part limitée dans la constitution du coût du toit, on conçoit que la différence ne soit pas insignifiante pour les constructeurs.

Par ailleurs dans les réalisations antérieures, l'utilisation d'une feuille de verre dont la transmission énergétique est aussi élevée que possible, pour améliorer le rendement des cellules photovoltaïques, est directement contraire aux exigences des constructeurs pour ce qui concerne la transmission dans l'habitacle. Pour des raisons de confort thermique, la transmission énergétique doit être la plus faible possible, et ne pas dépasser 20% , et de préférence être inférieure à 15%. L'utilisation de verres clairs, et, a fortiori de verres extra clairs, ne pouvait donc être envisagée si une partie du toit seulement reçoit les cellules, le reste étant aménagé pour la vision des passagers.

Il est possible pour satisfaire aux conditions contradictoires rappelées précédemment, de procéder au dépôt d'une couche mince limitant la transmission suivant une technique traditionnelle. Le dépôt doit néanmoins se limiter aux parties de la feuille qui ne comportent pas de cellules, ce qui ajoute à la complexité de l'opération. Par ailleurs, la couche, quelle que soit la technique utilisée pour sa formation, est relativement fragile, et, à l'intérieur de l'habitacle, elle reste exposée à tous les risques de dégradation par rayure, abrasion etc. Les défauts qui résultent de telles dégradations sont extrêmement sensibles dans la mesure où la couche absorbe et/ou réflêchit une part importante de la lumière incidente. Les défauts de cette couche apparaissent alors comme autant de points ou traits lumineux sur une surface qui l'est nettement moins.

L'invention propose, des toits de véhicules vitrés contribuant à la rigidité de la structure du véhicule présentant une structure nouvelle répondant aux nécessités exposées précédemment. Les vitrages selon l'invention comportent au moins une partie transparente, et au moins une partie qui n'est pas transparente, notamment du fait de la présence de cellules photovoltaïques ou d'autres éléments fonctionnels. Cette solution offre par ailleurs un certain nombre d'avantages qui seront précisés dans le cours de la description.

Dans ce qui suit, on fait référence à un toit de véhicule. Cette désignation comprend le cas où la totalité du toit est envisagée. Le cas du toit complet est celui qui correspond cependant le mieux aux buts poursuivis lorsque l'on s'efforce de disposer d'une surface aussi large que possible pour les cellules, sans pour autant renoncer aux autres aspects. Par ailleurs la tendance en matière de "design" automobile, rappelée ci-dessus, est clairement vers un accroissement de la surface vitrée. Les réalisations selon l'invention, suivant cette tendance, sont donc en faveur d'un toit entier en matériau verrier. La suite de la description et des exemples présente le cas du toit vitré entier sans que ceci soit limitatif.

Le toit selon l'invention présente au moins une partie transparente, et une partie non transparente du fait de la présence d'éléments fonctionnels eux mêmes non transparents. Il comprend une première feuille de verre constituant la face externe, une deuxième feuille de verre constituant au moins une partie de la face interne du toit, et une feuille intercalaire d'un ou plusieurs matériaux thermoplastiques traditionnellement utilisés pour former des vitrages feuilletés, intercalaire qui s'étend au moins sur les surfaces des feuilles de verre en regard l'une de l'autre. Les éléments fonctionnels non transparents, tels que les cellules photovoltaïques, sont disposés sous la première feuille de verre.

Dans la suite, par commodité il est fait référence aux cellules photovoltaïques en tant qu'éléments fonctionnels. Cet exemple est particulièrement représentatif de ce que peuvent être ces éléments. Mais il peut s'agir de tout autre dispositif non transparent et qui recouvrirait une part significative de la surface du toit.

L'ensemble des caractéristiques des éléments superposés dans la partie transparente du vitrage, est tel que la transmission énergétique sur cette partie n'est pas supérieure à 25%, et de préférence reste inférieure à 20%. Toujours dans la partie transparente, la transmission lumineuse est au plus de 35%, et le plus souvent est inférieure à 30%.

Le choix de la première feuille de verre, lorsque les éléments fonctionnels sont des cellules photovoltaïques, est tel que sa transmission énergétique, TE, est au moins de 82%, et de préférence supérieure à 87%.

La structure feuilletée peut s'étendre sur l'ensemble du vitrage ou ne concerner qu'une partie de celui-ci. La partie transparente du toit est toujours feuilletée. A l'inverse, la partie non transparente du toit, partie où les cellules se situent, peut ne comporter que la feuille de verre externe.

Dans le cas d'un vitrage partiellement feuilleté, il est avantageux de faire en sorte que la première feuille de verre, qui est celle qui présente les plus grandes dimensions, soit la seule qui repose sur la carrosserie. Il est important, pour des raisons d'assemblage et d'étanchéité, d'éviter les différences de niveau. Pour cela, le choix des dimensions des feuilles doit conduire à une première feuille dont tout le pourtour est libre sur quelques millimètres. Autrement dit la deuxième feuille de verre est toujours en retrait d'une distance au moins égale à celle nécessaire pour le positionnement du vitrage sur la carrosserie.

Par un choix approprié des feuilles de verre et, le cas échéant, des autres constituants de l'ensemble feuilleté: couches, émaillage ou qualité de l'intercalaire, il est possible de satisfaire aux exigences en matière de transmission énergétique dans l'habitacle. Ces exigences sont directement contraires à celles concernant l'exposition des cellules. Autrement dit le feuilletage permet de satisfaire des exigences distinctes et opposées selon la partie du vitrage considérée.

Tous les toits selon l'invention répondent aussi aux exigences de résistance mécanique des constructeurs. Le toit contribue en effet à la rigidité d'ensemble de la structure. Quelle que soit la forme choisie, toit entièrement ou partiellement feuilleté, les toits selon l'invention confèrent les propriétés mécaniques requises dans les conditions indiquées dans ce qui suit.

Si une partie seulement est feuilletée et transparente, l'autre partie qui porte les cellules étant non transparente, les propriétés mécaniques peuvent être en partie obtenues par des éléments de renfort de structure tels que des profilés métalliques ou tôles situés sous la partie non feuilletée du vitrage. Ces éléments qui s'intègrent à la carrosserie du véhicule, ne constituent aucune gêne compte tenu du fait qu'ils se situent dans une partie non transparente du toit. Ces éléments de structure supplémentaires, mais aussi les cellules et les conducteurs divers, sont alors masqués du côté de l'habitacle par des revêtements et parements traditionnels.

Le fait d'utiliser un vitrage en partie feuilleté, au lieu d'un vitrage entièrement feuilleté, permet par ailleurs un allégement sensible. Cet aspect est d'autant plus significatif, que la deuxième feuille de verre, qui est de dimensions limitées, est aussi celle dont l'épaisseur est normalement la plus importante pour les raisons exposées plus loin relatives notamment à la transmission énergétique.

Lorsque le vitrage entier est feuilleté, la résistance mécanique propre à ce type de structure suffit pour atteindre les performances requises. Il n'est alors pas nécessaire de disposer des éléments supplémentaires de renfort sous la partie non transparente du vitrage

Dans la construction selon l'invention, les feuilles sont assemblées suivant les techniques usuelles pour l'obtention de vitrages feuilletés.

L'assemblage feuilleté permet en particulier, par rapport aux constructions de l'art antérieur, de diminuer l'épaisseur de la feuille de verre qui protège les cellules lorsque le feuilletage est réalisé sur le vitrage entier et que les cellules sont placées entre les deux feuilles de verre. Une part importante de la résistance de l'ensemble est alors conférée par la deuxième feuille de verre dont les caractéristiques de transmission énergétique, et donc d'épaisseur, ne sont pas commandées par la présence des cellules photovoltaïques.

Si la première feuille est avantageusement de faible épaisseur, l'épaisseur totale de l'assemblage feuilleté influe sur les propriétés mécaniques. Les considérations de poids, comme pour les vitrages monolithiques, conduisent à limiter cette épaisseur. On s'efforce de maintenir l'épaisseur totale inférieure à 10mm, et de préférence inférieure à 7mm.

Comme indiqué ci-dessus, selon que l'ensemble feuilleté s'étend sur pratiquement toute la surface vitrée ou se limite à la partie transparente du toit, l'épaisseur de la première feuille de verre est sensiblement différente. Dans les deux cas cependant la première feuille de verre contribue à la résistance mécanique de l'ensemble. Dans le premier cas la feuille de verre externe doit présenter une épaisseur suffisante pour résister convenablement aux efforts extérieurs, indépendamment de la question de la rigidification de l'habitacle. Dans le second cas, la contribution de la première feuille de verre à cette rigidification est plus significative.

Pour ces raisons, dans le premier cas on utilise avantageusement des feuilles dont l'épaisseur n'est pas inférieure à 1 mm. A l'inverse, pour conserver l'avantage énergétique même avec les verres sodo-calciques ordinaires, l'épaisseur de cette première feuille n'est pas supérieure à 3mm. Le plus couramment cette épaisseur est comprise entre 1,5 et 2,5mm. Pour les verres "clairs" et "extra-clairs", l'épaisseur de la première feuille peut être plus importante, sans perdre le bénéfice d'un taux élevé de transmission énergétique. Pour ces verres clairs, l'épaisseur peut atteindre 5mm.

Dans le second cas - celui d'un "feuilletage partiel"- l'épaisseur dépend de la présence ou non d'éléments de renfort de la structure. Cette épaisseur est nécessairement plus importante que dans le premier cas, et est avantageusement de 2 à 6mm, et de manière préférée de 3 à 5mm.

La première feuille peut, bien entendu, être en verre extra clair pour optimiser la transmission. Dans ce cas, la transmission énergétique de la feuille peut dépasser 90%. Si on utilise une feuille de verre clair, la transmission énergétique, toujours dans les conditions d'épaisseur indiquées précédemment, est un peu moins élevée mais reste supérieure à 85%. A titre indicatif pour un verre extra clair du commerce, en 4mm d'épaisseur, la transmission énergétique est de 90,7. Pour un verre clair du commerce, toujours sous 4mm, la transmission énergétique est de 89,5. Bien évidemment, ces transmissions sont d'autant plus élevées que la feuille considérée est plus mince.

La deuxième feuille de verre est choisie de manière à procurer la résistance nécessaire au moins dans la partie transparente. Les considérations relatives à son épaisseur pour ce qui concerne la transmission lumineuse sont opposées à celles concernant la première feuille. En effet, pour que le toit permette une vision vers l'extérieur, tout en limitant la transmission énergétique dans l'habitacle, cette deuxième feuille doit être très absorbante, et l'épaisseur est un facteur important dans l'établissement de cette absorption. En pratique cependant il faut établir un compromis entre l'accroissement de l'épaisseur, favorable à la résistance mécanique et à l'absorption, d'une part, et la nécessité de maintenir le poids dans des limites raisonnables, d'autre part.

D'un point de vue mécanique, dans un assemblage feuilleté, et en association avec les premières feuilles décrites ci-dessus, des feuilles de 2 à 5mm et, de préférence, de 2,5 à 4mm, permettent de satisfaire aux normes dans ce domaine. Pour ces épaisseurs, et pour obtenir une transmission énergétique ne dépassant pas 25%, et de préférence 20%, on utilise en particulier des verres fortement colorés.

L'importance du rôle de la deuxième feuille de verre dans la réalisation des toits selon l'invention nous conduit à préciser leur nature.

Des verres colorés utiles selon l'invention sont connus de l'art antérieur. Parmi les verres qui permettent de réduire de manière très importante la transmission énergétique on préfère ceux qui en transmission ont une coloration neutre, bleutée, ou bleu-vert. Dans tous les cas les constructeurs demandent une pureté de coloration, au sens de la CIE (Commission Internationale de l'Eclairage), aussi faible que possible. Le choix de ces verres a pour but de faire en sorte que la lumière transmise dans l'habitacle ne déforme pas les couleurs.

On utilise ainsi avantageusement une feuille de verre gris dont la pureté d'excitation est inférieure à 10%, et qui, sous une épaisseur de 4mm, a une transmission lumineuse (TLA) inférieure à 25%, et de préférence inférieure à 20%. Des verres correspondant à ces conditions sont par exemple des verres sodo-calciques dont les composants de structure sont de façon traditionnelle dans les teneurs pondérales suivantes:

| | | | |
|---|---|---|---|
| $SiO_2$ | 60-75 % | $Al_2O_3$ | 0-5 % |
| $Na_2O$ | 10-20% | BaO | 0-2 % |
| CaO | 0-16 % | BaO+CaO+MgO | 10-20 % |
| $K_2O$ | 0-10 % | $K_2O+Na_2O$ | 10-20 % |
| MgO | 0-10 % | | |

A ces composants s'ajoutent des constituants chromophores notamment : $Fe_2O_3$, Co, Se, $Cr_2O_3$. Des verres "gris" de ce type sont notamment ceux dont les agents chromophores sont dans les teneurs :

| | | |
|---|---|---|
| $Fe_2O_3$ | 1-1,65 | % |
| Co | 0,017-0,030 | % |
| Se | 0,001-0,0100. | % |

Une autre combinaison de chromophores avantageuse comprend en plus de l'oxyde de chrome. Des teneurs préférées sont par exemple :

| | | |
|---|---|---|
| $Fe_2O_3$ | 0,75-1,8 | % |
| Co | 0,0040-0,0180 | % |
| Se | 0,0003-0,0040 | % |
| $Cr_2O_3$ | 0,0010-0,0100 | % |

Des verres de ces types sont décrits de façon détaillée notamment dans les publications FR-A 2 738 238 et 2 738 240.

Tous les verres précédents sont très neutres et "gris" en transmission. Le cas échéant, comme indiqué précédemment, les toits selon l'invention peuvent présenter une nuance bleutée. Pour atteindre ce type de vitrage il est avantageux d'utiliser pour deuxième feuille un verre dont les constituants chromophores sont essentiellement les oxydes de fer et le cobalt dans les proportions pondérales:

| | | |
|---|---|---|
| $Fe_2O_3$ (fer total) | 1,1-1,8 | % |
| FeO | 0,30-0,50 | % |
| Co | 0,0030-0,0270 | % |

auxquels s'ajoutent éventuellement d'autres agents dans les limites indiquées ci-après :

| | | |
|---|---|---|
| $Cr_2O_3$ | 0-0,0250 | % |
| $V_2O_5$ | 0-0,0500 | % |
| $CeO_2$ | 0-0,5 | % |
| $TiO_2$ | 0-1,5 | % |
| Se | 0-0,0100 | % |

Des verres bleus répondant à cette définition sont décrits de façon détaillée dans la demande de brevet européen déposée le 22 décembre 1998 sous le n°98 124 371.0 (EP1013620).

Il est également possible, d'utiliser un verre à forte sélectivité (rapport TLA/TE) tels que ceux dont les chromophores sont en proportions :

| $Fe_2O_3$ (fer total) | 1,2-1,85 | % |
|---|---|---|
| FeO | 0,40-0,50 | % |
| Co | 0,0020-0,013 | % |
| $Cr_2O_3$ | 0-0,0240 | % |
| $V_2O_5$ | 0-0,1 | % |
| Se | 0-0,0015 | % |

Ces verres sont de couleur très foncée avec une nuance verte à bleue. Leur sélectivité dépasse souvent 1,65. Ils sont décrits de façon détaillée dans la demande de brevet français déposée le 31 juillet sous le n°98/10020.

Une autre série de verres colorés très sélectifs et à faible transmission énergétique, utilisables pour former la deuxième feuille de la partie feuilletée du toit, correspond aux compositions dans lesquelles les chromophores sont :

soit

| $Fe_2O_3$ (fer total) | 1,2-1,8 | % |
|---|---|---|
| FeO | 0,25-0,35 | % |
| Co | 0,0020-0,010 | % |
| $Cr_2O_3$ | 0,001-0,0100 | % |
| $CeO_2$ | 0,1-0,8 | % |

soit

| $Fe_2O_3$ (fer total) | 0,9-1,8 | % |
|---|---|---|
| FeO | 0,25-0,40 | % |
| Co | 0,0010-0,010 | % |
| $Cr_2O_3$ | 0-0,0240 | % |
| $V_2O_5$ | 0-0,2 | % |

Ces verres très colorés également, sont gris verts. Ils ont une sélectivité normalement supérieure à 1,5. Ils sont décrits dans la publication EP-A 0887320.

Les caractéristiques colorimétriques de la deuxième feuille de verre de préférence satisfont aux relations suivantes :

$$P<20$$

$$R>-P+80$$

dans lesquelles P est la pureté d'excitation (CIE) mesurée sous 4mm d'épaisseur, avec l'illuminant C, sous un angle solide d'observation de 2°. et R l'indice de rendu des couleurs tel que défini dans la norme EN 410. Ce dernier indice traduit l'observation au travers d'un vitrage déterminé, d'un ensemble de huit échantillons de couleur éclairés par l'illuminant de référence $D_{65}$. L'indice de rendu des couleurs est d'autant plus élevé que la présence du vitrage modifie moins la perception des couleurs. Les verres gris proposée sont ceux dont l'indice de rendu des couleurs est le plus élevé. Il est généralement supérieur à 80% et peut atteindre et même dépasser 90%. Comparativement les verres qui confèrent une nuance bleutée, ont dans l'ensemble un indice plus faible qui se situe à environ 75%. De façon générale, on utilise pour constituer les toits selon l'invention des feuilles dont l'indice de rendu des couleurs n'est pas inférieur à 70 et de préférence 75%.

Les verres les plus neutres, et qui sont de couleur grise répondent avantageusement aux conditions :

$$P < 10$$

$$R > -P + 90$$

L'usage de verres très colorés conduit normalement aux transmissions recherchées. Si néanmoins le verre choisi ne réduit pas suffisamment la transmission, ou si l'on préfère utiliser un verre moins fortement coloré, il est possible de conférer les propriétés de transmission recherchées par l'utilisation d'une couche mince absorbante et/ou réfléchissante traditionnelle, par exemple une couche à base de nitrure de titane ou de chrome, une couche d'oxyde d'étain éventuellement dopée, une couche d'oxyde d'indium et d'étain etc. Dans l'hypothèse de la mise en oeuvre d'une telle couche, cette dernière est avantageusement soustraite aux risques de dégradation, en la disposant sur la face de la feuille de verre qui se trouve au contact de l'intercalaire.

Pour pouvoir réaliser une couche couvrant uniformément la feuille, elle est de préférence située sur la deuxième feuille de verre. On s'affranchit de cette façon de la nécessité de délimiter précisément la couche par rapport aux emplacements des cellules. A l'inverse, si la couche est appliquée sur la première feuille, les emplacements correspondant aux cellules doivent être l'objet de réserves pour conserver la transmission la plus forte possible à ces emplacements.

Un autre moyen pour réduire la transmission lumineuse, qui peut être utilisé selon l'invention, consiste à disposer un émaillage suivant un motif constitué de points de très petites dimensions suivant une trame dense. Les points doivent être de dimension suffisamment petite pour que l'observation depuis l'habitacle ne permette pas de les discerner. Ils sont en dessous du seuil de résolution. Des points de quelques dixièmes de millimètre espacés d'environ 0,5 à 2 mm peuvent être choisis.

Dans la mise en oeuvre d'un motif émaillé limitant la transmission, la fraction de la surface couverte détermine celle du rayonnement non transmis. Il est possible de faire varier cette fraction dans de très larges proportions. Tout en conservant une certaine "transparence" d'ensemble, l'émail peut recouvrir jusqu'à 70% de la surface. Avantageusement, on ne dépasse pas 60%.

Lorsqu'un motif de points émaillés est utilisé, il peut être réalisé sur l'une ou l'autre des feuilles de verre pour autant que ce motif ne masque pas les cellules.

Entre les deux feuilles de verre se trouve une feuille intercalaire d'un matériau thermoplastique. L'indication "d'une" feuille n'exclut pas qu'il puisse y avoir au moment de la formation du feuilletage plusieurs feuilles d'un même matériau ou de matériaux différents. La feuille thermoplastique peut également être formée dans l'assemblage à partir d'un état différent, notamment par polymérisation ou réticulation d'un matériau à l'état liquide. L'indication feuille intercalaire correspond donc à la forme finale dans l'assemblage, et ne concerne pas l'état du matériau initial, même si la forme la plus usuelle est bien celle d'une feuille.

Les feuilles intercalaires sont celles habituellement utilisées dans les vitrages feuilletés. Il s'agit en particulier des feuilles de polyvinylbutyral (PVB), d'acétate de polyvinyle (EVA), de polyuréthanne (PU) ou de chlorure de polyvinyle (PVC).

Lorsque les cellules sont prises entre deux feuilles de verre, l'épaisseur de la feuille, ou des feuilles intercalaires doit être au moins égale à celle des cellules photovoltaïques disposées dans l'assemblage. Dans la pratique les cellules ont entre 0,1 et 1mm d'épaisseur. Les intercalaires des feuilletés usuels présentent une épaisseur de l'ordre de 0,3 à 2mm. Ces épaisseurs conviennent donc bien, que les cellules soient prises dans le feuilletage ou non.

L'absorption des feuilles intercalaires est en général suffisamment faible pour n'avoir qu'une incidence limitée sur les caractéristiques de transmission de l'ensemble. Il est néanmoins possible, lorsque plusieurs feuilles sont utilisées pour constituer l'intercalaire, de combiner leurs caractéristiques pour répondre aux objectifs poursuivis par l'invention. Il est en particulier possible dans le cas des cellules prises entre les deux feuilles de verre, de disposer sous les cellules une feuille d'un matériau qui contribue à l'absorption lumineuse sans entraver le rayonnement reçu par les cellules. On peut en particulier utiliser des matériaux tels que les PVB colorés dont la transmission énergétique pour des épaisseurs type de 0,76mm peut être aussi faible que 15%, Bien entendu, les produits commercialisés permettent de réaliser toute une gamme de transmissions de valeurs intermédiaires.

Lorsque les cellules sont disposées dans une partie non feuilletée du vitrage, leur mise en place peut être avantageusement obtenue par collage sur la première feuille de verre. Le collage peut être réalisé au moyen d'adhésifs variés sous la condition que ces adhésifs ne fassent pas obstacle à la transmission énergétique vers les cellules. On peut aussi fixer les cellules au moyen de la feuille thermoplastique servant au feuilletage. Dans ce cas, la feuille thermoplastique s'étend au delà de la partie feuilletée pour couvrir aussi la zone des cellules. Une feuille d'EVA est particulièrement bien adaptée à ce type de construction. Dans un autre mode de réalisation, les cellules peuvent également être fixées par une feuille d'adhésif disposée de manière à les envelopper.

Quand les cellules sont dans le feuilletage le mode d'introduction dans l'intercalaire dépend en partie de la malléabilité de celui-ci. Pour les produits facilement déformables, il est possible d'imprimer dans la feuille l'empreinte correspondant à la cellule qu'on loge ensuite dans ladite empreinte. Pour les feuilles moins facilement déformables, il peut être préférable d'associer au moins deux feuilles dont une d'épaisseur sensiblement égale à celle des cellules. Cette feuille est poinçonnée pour découper des logements aux dimensions des cellules. Elle est ensuite associée à au moins une feuille pour constituer un ensemble analogue à la feuille imprimée décrite précédemment. Dans les deux cas, en tant que de besoin , à l'ensemble portant les cellules et les connections électriques, est superposée une feuille supplémentaire pour envelopper complètement la cellule dans un produit relativement souple, et éviter le contact avec les surfaces des feuilles de verre.

Pour faciliter l'incorporation des cellules dans l'intercalaire, on peut aussi combiner les caractéristiques de différents matériaux. Il est possible par exemple d'associer une feuille préformée de PVB comportant des logements pour les cellules, avec un film souple, par exemple d'EVA, qui permet une enduction et une adhésion parfaitement uniformes de la cellule dans l'intercalaire.

Pour des raisons d'esthétique il est aussi avantageux selon l'invention de masquer les bords des cellules, ou au moins ceux comportant des connexions électriques, ainsi que les conducteurs, et de façon générale toute partie qui introduit une discontinuité dans l'apparence du produit, par le dépôt d'émaux suivant des motifs obtenus par sérigraphie. Ces parties émaillées lorsqu'elles sont destinées à masquer les discontinuités apparentes depuis l'extérieur, sont établies sur la première feuille de verre.

Le toit selon l'invention est feuilleté suivant les techniques traditionnelles. Typiquement pour des feuilles intercalaires préformées, comme des feuilles de PVB, on procède habituellement en deux étapes: une première étape de dégazage suivie d'une étape de collage. La technique utilisée est notamment celle décrite dans la publication FR-A 2428920, à propos de l'encapsulation de cellules photovoltaïques dans un ensemble feuilleté.

D'autres modes de feuilletage sont aussi utilisables, notamment lorsque l'on procède avec un matériau liquide pour constituer l'intercalaire.

L'invention est décrite dans la suite en faisant référence aux dessins dans lesquels:

- la figure 1 est une vue schématique en coupe d'un assemblage pour toit selon l'invention;
- la figure 2 est une vue en coupe d'un mode de réalisation de l'insertion des cellules photovoltaïques selon l'invention;
- la figure 3 est une vue en coupe d'un autre mode d'insertion des cellules photovoltaïques;
- la figure 4 est une vue schématique en perspective d'un toit équipé de cellules photovoltaïques;
- la figure 5 est une vue en coupe selon B-B de la figure 4;
- la figure 6 est une vue en coupe selon A-A de la figure 4;
- la figure 7 est une vue schématique en perspective, analogue à la figure 4, dans laquelle le feuilletage est limité à la seule partie transparente;
- la figure 8 est une coupe d'une partie d'un vitrage du type de celui de la figure 7.

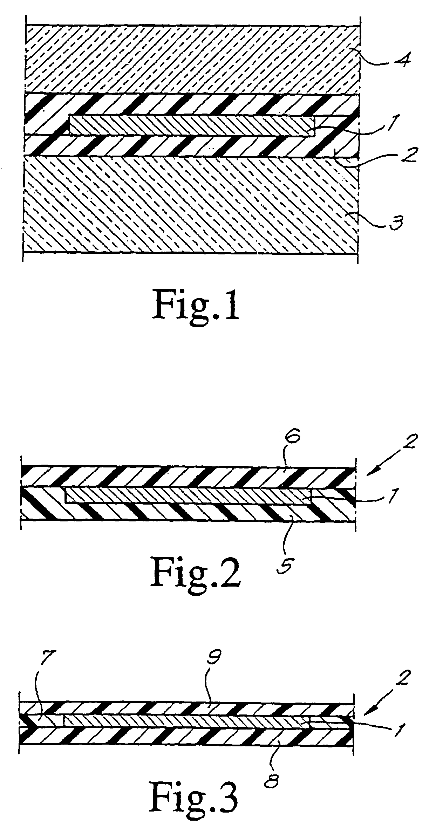

La coupe de la figure 1 comprend une cellule photovoltaïque, schématisée 1, avec des conduits de connexion. La cellule est enveloppée dans un intercalaire 2, constitué par exemple par du PVB incolore. La figure montre le matériau de l'intercalaire comme homogène. Cette structure est celle que l'on peut constituer après les opérations de feuilletage, à partir de feuilles initialement séparées comme montré à propos des figures 2 et 3. Cette structure de l'intercalaire peut aussi être obtenue lorsque l'on utilise un matériau qui se trouve à l'état liquide avant l'opération de feuilletage.

La face externe de l'assemblage est constituée par une feuille de verre 4, dont les caractéristiques , composition et épaisseur, sont telles que la transmission lumineuse est la plus élevée possible, et n'est pas inférieure à 82%. La face interne, c'est-à-dire celle tournée vers l'habitacle, est constituée par une feuille de verre 3 dont la transmission lumineuse ne dépasse pas 35%.

Le matériau constituant l'intercalaire est avantageusement aussi peu absorbant que possible, pour que le rayonnement incident ayant traversé la feuille 4 parvienne presque intégralement sur la cellule. Dans le cas d'un matériau absorbant , on maintient l'épaisseur de matériau séparant la cellule de la feuille 4 aussi petite que possible. Il est préférable de conserver un minimum de matériau intercalaire entre la cellule et la feuille 4, pour protéger la cellule contre un risque de détérioration au moment des opérations d'assemblage. La pression exercée sur la cellule est alors répartie de manière plus homogène sur toute la cellule du fait de l'élasticité du matériau de l'intercalaire.

La feuille 4 est représentée sensiblement moins épaisse que la feuille 3. Comme indiqué plus haut, il est préférable de maintenir l'épaisseur de la feuille 4 aussi petite que possible pour limiter son absorption. A l'inverse, la feuille 3 qui participe de façon prépondérante à l'établissement des propriétés mécaniques requises de l'assemblage est avantageusement plus épaisse.

La figure 2 montre un moyen d'insertion de la cellule dans le matériau intercalaire. Dans le cas représenté, la cellule est prise entre deux feuilles 5 et 6. Pour éviter de soumettre la cellule à une pression excessive lors de l'assemblage, un logement correspondant à ses dimensions est estampé dans l'une des feuilles (sur la figure la feuille 6). Les matériaux utilisés sont suffisamment malléables pour se prêter sans difficulté à ce type de mise en forme. Une fois la cellule mise en place dans son logement, la feuille 6 recouvre l'ensemble, et l'on procède au feuilletage suivant les modalités habituelles. Par exemple, l'intercalaire étant placé entre les deux feuilles de verre 3 et 4, on procède tout d'abord à un dégazage sous vide partiel. Simultanément, on prévient l'établissement d'une pression sur les faces des feuilles de verre, pression qui rendraient le dégazage plus difficile. Après dégazage, la température de l'ensemble est progressivement accrue, cette fois en laissant la pression extérieure s'exercer. Les dernières traces d'air sont alors dissoutes dans le matériau qui colle aux feuilles de verre. Simultanément les feuilles 5 et 6 se soudent l'une à l'autre pour ne constituer qu'une seule masse dans laquelle les cellules sont incorporées.

La figure 3 présente un principe analogue au précédent. Pour constituer l'intercalaire, par exemple trois feuilles de PVB 7, 8 et 9 sont réunies. La feuille intermédiaire 7, dont l'épaisseur correspond approximativement à celle des cellules, est poinçonnée. Les ouvertures pratiquées dans la feuille 7 reçoivent les cellules et l'on procède comme précédemment après avoir placé deux feuilles 8 et 9, de part et d'autre de la feuille 7.

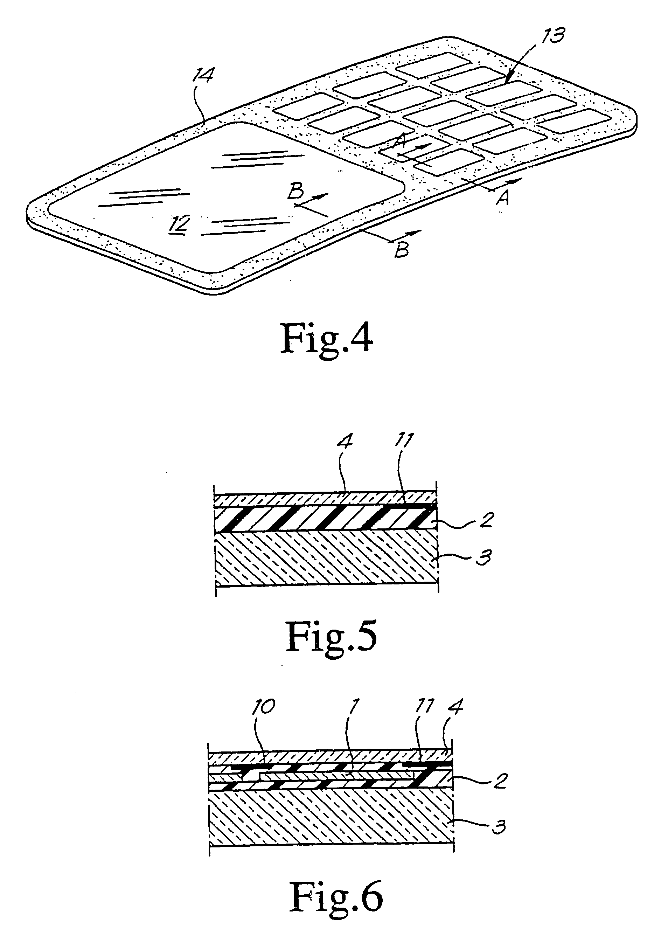

La figure 4 présente un voit automobile selon l'invention. Le toit comporte deux zones fonctionnelles distinctes. La zone 12 correspond à une partie transparente permettant la vision depuis l'habitacle. La zone 13 est celle équipée de cellules. Sur cette figure on a représenté de façon très accentuée, un motif émaillé 14, destiné à masquer par exemple la fixation de la périphérie du toit et les intervalles entre les cellules , intervalles dans lesquels sont placés les conduits électriques. Sur cette figure l'émaillage est établi sur le pourtour de chaque cellule. Si il s'agit de ne masquer que les conducteurs, l'émaillage peut être limité à des bandes longitudinales ou transversales, et non à un quadrillage comme représenté. Le détail de la structure apparaît aux figures 5 et 6.

Dans la zone 12 destinée à la vision, L'assemblage es formé des deux feuilles de verre 3 et 4, et de l'intercalaire 2. Sur le bord du toit se trouve une bande émaillée 11. L'émaillage est avantageusement réalisé sur la feuille externe 4, et, plus précisément, sur la face de cette feuille en contact avec l'intercalaire. De la même façon, la figure 6 montre une bande émaillée 10 masquant la jonction entre deux cellules voisines.

Dans cette zone 12 la transmission lumineuse, même très réduite, du fait des caractéristiques de la feuille de verre 3, est suffisante pour permettre aux passagers de voir depuis l'habitacle à travers le toit. A l'inverse, de l'extérieur, la vision de l'habitacle, lorsque celui-ci n'est pas éclairé, est pratiquement nulle. De l'extérieur le toit parait presque uniformément sombre, et sur ce fond, on distingue tout juste les bandes émaillées.

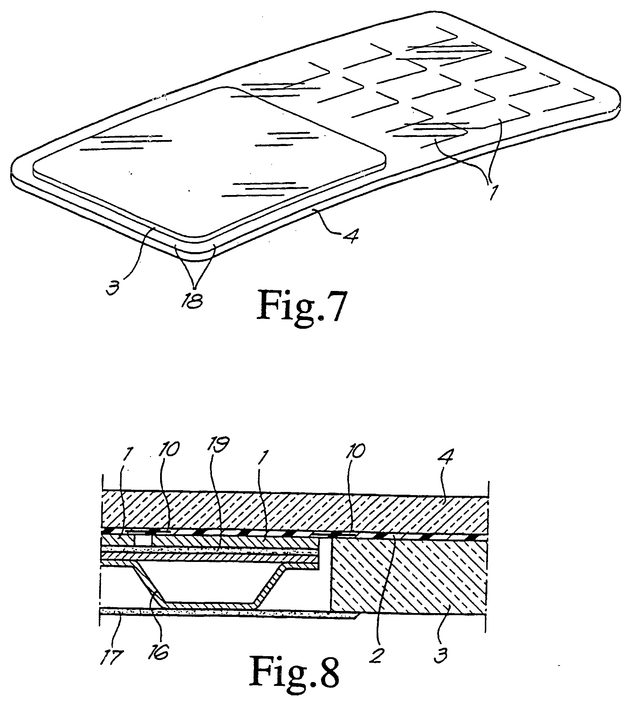

Dans la zone 13, l'ensemble des motifs émaillés et des cellules photovoltaïques recouvre toute la surface. Cette partie n'est pas transparente. Les cellules qui sont recouvertes par une feuille de verre offrant une très forte transmission sont dans les meilleures conditions d'efficacité. La figure 7 montre de manière schématique un mode de réalisation de l'invention dans lequel la partie feuilletée est distincte de celle portant les cellules. La figure ne présente que le vitrage et l'emplacement occupé par les cellules.

Dans cette forme, la partie feuilletée transparente ne recouvre pas la totalité de la largeur du toit vitré. Une zone périphérique 18 de la feuille externe 4 est hors du feuilletage. Les cellules sont disposées sur la feuille 4 par exemple par collage. Le cas échéant les zones 18 de même que les intervalles entre les cellules peuvent recevoir un émail comme pour la réalisation de la figure 4. La feuille intercalaire, non représentée, s'étend sous la feuille 3, y compris dans la partie occupée par les cellules 1. Elle ne couvre pas les zones 18, réservées pour la fixation sur la carrosserie du véhicule par des moyens de fixation spécifiques.

Les zones 18 sont normalement limitées en largeur. Elles ont pour but de conserver sur l'ensemble de la périphérie du vitrage le même niveau. Il est important pour une bonne fixation sur la carrosserie qu'il n'apparaisse aucune discontinuité de niveau. La largeur nécessaire pour la mise en place du vitrage sur la carrosserie est généralement de l'ordre de 20 à 50mm.

La figure 8 montre le détail d'une structure du type de celle de la figure 7. La coupe de cette figure se situe à la transition entre la partie feuilletée et celle portant les cellules photovoltaïques. La feuille externe 4 recouvre l'ensemble. Les cellules 1 sont disposées en dehors de la partie feuilletée sous la feuille 4. Elles sont collées à la feuille 4 au moyen de l'intercalaire 2, constitué par exemple d'une feuille d'EVA. Comme précédemment, les contours des cellules, de même que les limites entre les parties feuilletées et non feuilletées, sont masqués par des bandes émaillées 10 disposées sur la face interne de la feuille 4.

La partie non feuilletée de la feuille 4 est supportée par des traverses métalliques tel qu'en 16. Un parement 17 recouvre l'ensemble du côté habitacle à l'exception de la partie feuilletée transparente. Pour l'esthétique le parement 17 couvre aussi le bord de la feuille 3. Pour éviter un contact direct des cellules avec les traverses 16, une feuille souple 19 est interposée. Cette feuille est par exemple un feutre ou une feuille de carton épais ou de matériau synthétique éventuellement expansé.

Dans le tableau suivant figurent les caractéristiques de transmission lumineuse (TLA), et énergétique (TE), pour différents verres ou assemblages feuilletés. La mesure de TE est selon Moon.

Pour ces ensembles la première feuille est en verre sodo-calcique clair ordinaire correspondant à la composition indiquée plus haut. La deuxième feuille est en verre gris de coloration conduisant à une absorption élevée du type décrit dans la publication FR-A2 738 240. Lorsqu'une couche athermique est présente, elle est disposée sur la deuxième feuille de verre. Il s'agit d'une couche à base d'oxyde d'étain dopé, d'environ 400 nanomètres d'épaisseur.

Les exemples 1 et 2 ont pour but de montrer le rôle significatif de la deuxième feuille de verre dans l'établissement de la transmission énergétique de l'ensemble constitué.

La comparaison entre les exemples 1 et 6, permet de montrer les rôles respectifs de la feuille grise, présente dans les deux cas, d'une part, et de la feuille de verre clair, et de l'intercalaire en PVB, présents uniquement dans l'exemple 6, d'autre part. Dans ce dernier cas, la transmission énergétique n'est abaissée que de 0,6%. En d'autres termes, la présence d'une feuille de verre clair de 1,8mm d'épaisseur et d'une feuille intercalaire de PVB de 1mm d'épaisseur atténue très peu le rayonnement reçu sur les cellules dans la configuration proposée selon l'invention dans laquelle les cellules sont dans la partie feuilletée

L'épaisseur de la deuxième feuille intervient de façon significative. On peut comparer à ce sujet les exemples 1 et 2, mais aussi 3 et 6.

La présence de la couche athermique permet aussi un contrôle efficace de la transmission énergétique de l'ensemble. Ceci, comme on peut le constater, permet le cas échéant de limiter l'épaisseur de la deuxième feuille de verre sans perdre la réduction de transmission énergétique dans l'habitacle.

|   | Epaisseur feuille 1 | Epaisseur PVB | Epaisseur feuille 2 | Couche | Epaisseur totale | TLA | TE |
|---|---|---|---|---|---|---|---|
| 1 |  |  | 3,15 |  |  | 24,1 | 21,4 |
| 2 |  |  | 4 |  |  | 16,9 | 14,7 |
| 3 | 2,5 | 1 | 4 |  | 7,5 | 16,5 | 14,3 |
| 4 | 1,5 | 0,76 | 3,15 | oui | 5,41 | 13,6 | 11,6 |
| 5 | 1,8 | 1 | 3,15 | oui | 5,95 | 13,6 | 11,5 |
| 6 | 1,8 | 1 | 3,15 |  | 5,95 | 23,7 | 20,8 |

Dans le second tableau figurent des données comparables à celles du premier tableau. La différence réside dans le choix du verre constituant la seconde feuille. Dans ce cas précis on choisit un verre gris encore plus absorbant que pour la première série. Ceci, comme on le constate, permet encore de diminuer de façon très substantielle la transmission énergétique pour la partie du toit qui ne comporte pas de cellules photovoltaïques. Pour ces exemples, les remarques précédentes concernant les caractéristiques de la première feuille de verre et de l'intercalaire, s'appliquent également. Autrement dit, la transmission reste élevée au niveau des cellules.

|    | Epaisseur feuille 1 | Epaisseur PVB | Epaisseur feuille 2 | Couche | Epaisseur totale | TLA | TE |
|----|---|---|---|---|---|---|---|
| 7  |  |  | 3,15 |  |  | 15,9 | 13.7 |
| 8  |  |  | 4 |  |  | 10 | 8,4 |
| 9  | 2,5 | 1 | 4 |  | 7,5 | 9,8 | 7.8 |
| 10 | 1,5 | 0,76 | 3,15 | oui | 5,41 | 9 | 7,1 |
| 11 | 1,8 | 1 | 3,15 | oui | 5,95 | 9 | 7 |
| 12 | 1.8 | 1 | 3,15 |  | 5,95 | 15,6 | 12,8 |

On voit sur ce tableau que la transmission énergétique peut être abaissée très significativement même sans avoir recours à des couches additionnelles, simplement par le choix d'un verre approprié pour la seconde feuille de verre.

D'autres assemblages ont été réalisés en utilisant un émaillage partiel de la partie "transparente" pour en atténuer la transmission. Les assemblages sont tous constitués d'une première feuille de verre "clair" de 2,5mm d'épaisseur, d'une feuille intercalaire de 0,76mm d'épaisseur et d'une feuille de verre gris, du type utilisé aux exemples 1 à 6, de 2,5mm d'épaisseur. L'émaillage est de préférence réalisé sur la première feuille, en même temps que le masquage des bords de la feuille et des conducteurs électriques.

Les exemples 13 à 16 correspondent à des feuilletages dans lesquels une proportion croissante de la surface de la partie transparente est revêtue par l'émaillage par points. Les exemples 17 à 20 sont analogues aux exemples 13 à 16, mais, en plus, une couche athermique est utilisée, comme celle décrite à propos des exemples 4, 5, 10 et 11. Par mesure de simplicité, il est préférable de déposer la couche athermique sur la feuille grise. De cette façon le dépôt peut revêtir toute la surface sans s'opposer à la transmission vers les cellules photovoltaïques.

Le tableau suivant donne les caractéristiques de transmission pour ces différents assemblages. A titre d'indication, la feuille de verre "clair", de 2,5mm d'épaisseur, présente une transmission lumineuse TLA de 91,5, et une transmission énergétique, TE, de 90,5. Ceci correspond pratiquement à ce que reçoivent les cellules.

|     | Emaillage % | Couche | TLA  | TE   |
| --- | ----------- | ------ | ---- | ---- |
| 13  |             |        | 33,5 | 30   |
| 14  | 50          |        | 16,5 | 15   |
| 15  | 60          |        | 13,5 | 12   |
| 16, | 70          |        | 12   | 9    |
| 17  |             | oui    | 18.5 | 15,5 |
| 18  | 50          | oui    | 9.5  | 8    |
| 19  | 60          | oui    | 7,5  | 6,5  |
| 20  | 70          | oui    | 5,5  | 5    |

Si l'émaillage partiel permet de réduire la transmission en proportion de la surface couverte, il ne peut être utilisé seul pour atteindre les transmissions les plus basses sans altérer le caractère "transparent" souhaité. Pour cela, lorsque la transmission doit être extrêmement faible , on combine avantageusement les différents moyens mis en oeuvre. Les exemples 18, 19 et 20 proposent ainsi les effets simultanés de la coloration de la deuxième feuille, de l'émaillage partiel et d'une couche athermique.

Aux figures 4 et 7, les vitrages représentés comportent une partie dans laquelle les cellules sont rassemblées. Des dispositions différentes peuvent être préférées selon les arrangements propres à chaque véhicule. Une autre disposition particulière consiste par exemple à disposer les cellules sur le pourtour du toit, laissant la partie transparente au centre de celui-ci. Cette disposition en ménageant les zones non transparentes sur la périphérie, peut améliorer l'esthétique en confondant les zones portant les cellules avec celles correspondant à la carrosserie, en "élargissant" ces dernières. Ces exemples ne sont bien entendu pas limitatifs des dispositions respectives possibles des zones transparentes et non transparentes des toits selon l'invention.


**Revendications**

1.  Toit de véhicule automobile vitré, la partie vitrée contribuant à la rigidité de la structure du véhicule, et présentant au moins une partie transparente feuilletée, comprenant :

    -   une première feuille de verre sur la face externe du toit;
    -   une deuxième feuille de verre sur au moins une partie de la face interne du toit tournée vers l'habitacle;
    -   une feuille intercalaire d'un ou plusieurs matériaux thermoplastiques traditionnellement utilisés pour former les vitrages feuilletés, intercalaire qui s'étend au moins sur les surfaces des feuilles de verre en regard l'une de l'autre;
    -   des éléments fonctionnels non transparents disposés sous la première feuille de verre;

    la partie transparente feuilletée présentant une transmission lumineuse inférieure à 35%, et une transmission énergétique inférieure à 20%.

2.  Toit selon la revendication 1 dans lequel la première feuille de verre présente une transmission énergétique d'au moins 82%.

3.  Toit selon la revendication 2 dans lequel les éléments fonctionnels non transparents comprennent des cellules photovoltaïques.

4.  Toit selon l'une des revendications précédentes, comprenant une partie feuilletée et une partie non feuilletée, la première feuille de verre étant de dimensions plus grandes que celles de la deuxième feuille de verre, et les éléments fonctionnels étant disposés sous la première feuille de verre, dans la partie de celle-ci qui n'est pas feuilletée.

5. Toit selon la revendication 4, dans lequel les éléments fonctionnels constitués par des cellules photovoltaïques, sont collés sur la face interne de la première feuille de verre.

6. Toit selon la revendication 5 dans lequel les cellules sont collées sur la feuille intercalaire qui s'étend au delà de la partie feuilletée, sous la première feuille de verre.

7. Toit selon l'une des revendications 4 à 6 dans lequel, du côté de l'habitacle du véhicule, sous la partie non feuilletée, sont disposés des éléments de structure et/ou des parements non transparents.

8. Toit selon une des revendications 4 à 7, dans lequel la première feuille de verre a une épaisseur de 2 à 6mm, et la deuxième feuille de verre une épaisseur de 2 à 5mm, l'ensemble feuilleté restant d'épaisseur inférieure ou égale à 10mm.

9. Toit selon l'une des revendications 1 à 3, dans lequel les feuilles de verre sont sensiblement de mêmes dimensions et forment un ensemble entièrement feuilleté, les éléments fonctionnels étant logés entre les feuilles de verre.

10. Toit selon la revendication 9 dans lequel la première feuille de verre a une épaisseur de 1 à 3mm, la seconde feuille de verre une épaisseur de 2 à 5mm, l'ensemble feuilleté restant d'épaisseur inférieure ou égale à 10mm.

11. Toit selon l'une des revendications précédentes dans lequel la feuille intercalaire est constituée à partir d'une ou plusieurs feuilles de matériaux thermoplastiques du groupe comprenant : les polyvinylbutyral (PVB), les copolymères d'éthylène et d'acétate de vinyle (EVA), les polyuréthannes (PU), les chlorures de polyvinyles (PVC).

12. Toit selon l'une des revendications 9 à 11 dans lequel , au cours de l'assemblage des feuilles, les éléments fonctionnels sont placés dans des logements ménagés par poinçonnage dans une feuille entrant dans la constitution de l'intercalaire, et la feuille poinçonnée est placée entre deux autres feuilles, entrant également dans la constitution de l'intercalaire.

13. Toit selon l'une des revendications 9 à 11, dans lequel, au cours de l'assemblage, les éléments fonctionnels sont placés dans des logements ménagés, par estampage, dans une feuille entrant dans la constitution de l'intercalaire, une deuxième feuille entrant également dans la constitution de l'intercalaire recouvrant la première.

14. Toit selon l'une des revendications précédentes, dans lequel l'épaisseur. totale de l'intercalaire, éventuellement constitué de plusieurs feuilles superposées, est comprise entre 0,3 et 2mm.

15. Toit selon l'une des revendications précédentes dans lequel la transmission de la partie transparente est contrôlée, au moins partiellement, au moyen d'un émaillage suivant un motif constitué de points de très petites dimensions disposés selon une trame dense, l'émaillage étant réalisé sur la face d'une des feuilles de verre au contact de l'intercalaire.

16. Toit selon l'une des revendications 1 à 14, dans lequel la transmission de la partie transparente est contrôlée, au moins partiellement, au moyen de couches minces déposées sur une des feuilles de verre, et sur la face de celle-ci au contact de l'intercalaire.

17. Toit selon la revendication 16, dans lequel l'une au moins des couches est du type athermique.

18. Toit selon la revendication 17, dans lequel la couche est à base de d'oxyde d'étain éventuellement dopé, d'oxyde d'indium et d'étain, de nitrure de titane ou de chrome.

19. Toit selon la revendication 16, dans lequel la couche est une couche réfléchissante à base d'argent.

20. Toit selon l'une des revendications précédentes dans lequel la face interne de la première feuille de verre comporte un émaillage dont le dessin recouvre la surface en réservant la partie transparente du vitrage et les emplacements des cellules.

**Patentansprüche**

1. Verglastes Kraftfahrzeugdach, wobei der verglaste Teil zur Steifigkeit der Struktur des Fahrzeugs beiträgt und mindestens einen transparenten, in Lagen aufgebauten bzw. laminierten Teil bzw. als Verbundglas ausgebildetes Glas aufweist, umfassend:

   - eine erste Lage aus Glas bzw. Glasband auf der äußeren Dachfläche;
   - eine zweite Lage aus Glas bzw. Glasband auf mindestens einem Teil der inneren Dachfläche, die zum Karosseriegehäuse gewandt ist;
   - eine Zwischenlage bzw. -schicht aus einem oder mehreren Thermoplasten, die herkömmlicherweise für die Bildung von Verbundglas verwendet werden, wobei sich die Zwischenlage mindestens auf den Flächen der Lagen aus Glas erstreckt, die einander gegenüber liegen;
   - nicht transparente Funktionselemente, die unter der ersten Lage aus Glas angeordnet sind;

   wobei der erste transparente, in Lagen aufgebaute Teil einen Lichtdurchlassgrad von weniger als 35 % und eine Energieübertragung von weniger als 20 % aufweist.

2. Dach nach Anspruch 1, bei dem die erste Lage aus Glas eine Energieübertragung von mindestens 82 % aufweist.

3. Dach nach Anspruch 2, bei dem die nicht transparenten Funktionselemente photovoltaische Zellen umfassen.

4. Dach nach einem der vorhergehenden Ansprüche, umfassend einen in Lagen aufgebauten Teil bzw. aus Verbundglas aufgebauten Teil und einen nicht in Lagen aufgebauten Teil bzw. nicht als Verbundglas ausgebauten Teil, wobei die erste Lage aus Glas größere Abmessungen als jene der zweiten Lage aus Glas aufweist, und wobei die Funktionselemente unter der ersten Lage aus Glas in dem Teil derselben angeordnet sind, der nicht in Lagen aufgebaut ist.

5. Dach nach Anspruch 4, bei dem die Funktionselemente, die von den photovoltaischen Zellen gebildet sind, auf die Innenseite bzw. -fläche der ersten Lage aus Glas geklebt sind.

6. Dach nach Anspruch 5, bei dem die Zellen auf die Zwischenlage geklebt sind, die sich über den in Lagen aufgebauten Teil hinaus unter der ersten Lage aus G!as erstreckt.

7. Dach nach einem der Ansprüche 4 bis 6, bei dem auf der Seite des Karosseriegehäuses bzw. Fahrzeuginnenraum des Fahrzeugs unter dem nicht in Lagen aufgebauten Teil nicht transparente Strukturelemente und/oder Verkleidungen angeordnet sind.

8. Dach nach einem der Ansprüche 4 bis 7, bei dem die erste Lage aus Glas bzw. Glasband eine Dicke von 2 bis 6 mm und die zweite Lage aus Glas bzw. Glasband eine Dicke von 2 bis 5 mm aufweist, wobei die in Lagen aufgebaute Einheit mit ihrer Dicke kleiner oder gleich 10 mm bleibt.

9. Dach nach einem der Ansprüche 1 bis 3, bei dem die Lagen aus Glas bzw. Glasbänder im Wesentlichen dieselben Abmessungen haben und eine zur Gänze in Lagen aufgebaute Einheit bzw. eine Verbundglaseinheit bilden, wobei die Funktionselemente zwischen den Lagen aus Glas bzw. Glasbändern angeordnet sind.

10. Dach nach Anspruch 9, bei dem die erste Lage aus Glas eine Dicke von 1 bis 3 mm, die zweite Lage aus Glas eine Dicke von 2 bis 5 mm aufweist, wobei die in Lagen aufgebaute Einheit eine Dicke kleiner oder gleich 10 mm hat.

11. Dach nach einem der vorhergehenden Ansprüche, bei dem die Zwischenlage aus einer oder mehreren Lagen aus Thermoplasten aus der Gruppe gebildet ist, die umfasst: Polyvinylbutyral (PVB), Copolymere von Ethylen und Vinylacetat (EVA), Polyurethane (PU), Polyvinylchloride (PVC).

12. Dach nach einem der Ansprüche 9 bis 11, bei dem während des Zusammenbaus der Lagen die Funktionselemente in Lagerungen bzw. Aufnahmen angeordnet sind, die durch Stanzen bzw. Laden bzw. Stempeln in eine Lage, die Teil der Zwischenlage ist, vorgesehen sind, und die gestanzte Lage zwischen zwei weiteren Lagen angeordnet wird, die ebenfalls Teil der Zwischenlage sind.

13. Dach nach einem der Ansprüche 9 bis 11, bei dem während des Zusammenbaus die Funktionselemente in Lagerungen bzw.Aufnahmen angeordnet sind, die durch Stanzen bzw. Formstanzen bzw. Prägen in einer Lage vorgesehen sind, die Teil der Zwischenlage ist, wobei eine zweite Lage, die ebenfalls Teil der Zwischenlage ist, die erste überdeckt.

14. Dach nach einem der vorhergehenden Ansprüche, bei dem die Gesamtdicke der Zwischenlage, die eventuell von mehreren übereinander liegenden Lagen gebildet ist, zwischen 0,3 und 2 mm liegt.

15. Dach nach einem der vorhergehenden Ansprüche, bei dem die Übertragung des transparenten Teils zumindest teilweise mit Hilfe einer Emaillierung nach einem Motiv kontrolliert wird, das aus Punkten mit sehr kleinen Abmessungen gebildet ist, die nach einem dichten Raster angeordnet sind, wobei die Emaillierung auf der Fläche einer der Lagen aus Glas hergestellt ist, die mit der Zwischenschicht in Kontakt sind.

16. Dach nach einem der Ansprüche 1 bis 14, bei dem die Übertragung des transparenten Teils zumindest teilweise mit Hilfe von dünnen Schichten, die auf einer der Lagen aus Glas und auf der Seite derselben, die mit der Zwischenschicht in Kontakt ist, aufliegen, kontrolliert wird.

17. Dach nach Anspruch 16, bei dem mindestens eine der Schichten wärmeundurchlässig bzw. arthermisch ist.

18. Dach nach Anspruch 17, bei dem die Schicht auf Basis von Zinnoxid ist, das eventuell mit Indium- und Zinnoxid, Titan- oder Chromnitrid dopiert ist.

19. Dach nach Anspruch 16, bei dem die Schicht eine reflektierende Schicht auf Basis von Silber ist.

20. Dach nach einem der vorhergehenden Ansprüche, bei dem die Innenseite der ersten Lage aus Glas eine Emaillierung trägt, deren Zeichnung die Oberfläche bedeckt, wobei der transparente Teil der Verglasung und die Stellen der Positionierung der Zellen frei bleiben.

## Claims

1. Glazed roof for a motor vehicle, wherein the glazed section contributes to the rigidity of the structure of the vehicle, having at least one laminated transparent section comprising:

   - a first glass sheet on the outside face of the roof;
   - a second glass sheet on at least one section of the inside face of the roof facing the passenger compartment;
   - an interlayer sheet composed of one or more thermoplastic materials traditionally used to form laminated glazing units, said interlayer extending at least over the surfaces of the glass sheets facing one another;
   - non-transparent functional elements disposed beneath the first glass sheet;

   the transparent laminated section having a light transmission of less than 35% and an energy transmission of less than 20%.

2. Roof according to Claim 1, wherein the first glass sheet has an energy transmission of at least 82%.

3. Roof according to Claim 2, wherein the non-transparent functional elements comprise photovoltaic cells.

4. Roof according to one of the preceding claims, comprising a laminated section and a non-laminated section, the first glass sheet having larger dimensions than those of the second glass sheet, and the functional elements being disposed beneath the first glass sheet in the section thereof, which is not laminated.

5. Roof according to Claim 4, wherein the functional elements formed by photovoltaic cells are glued onto the inside face of the first glass sheet.

6. Roof according to Claim 5, wherein the cells are glued onto the interlayer sheet, which extends beyond the laminated section beneath the first glass sheet.

7. Roof according to one of Claims 4 to 6, wherein non-transparent structural and/or lining elements are disposed beneath the non-laminated section on the passenger compartment side of the vehicle.

8. Roof according to one of Claims 4 to 7, wherein the first glass sheet has a thickness of 2 to 6 mm and the second glass sheet a thickness of 2 to 5 mm, the laminated assembly having a thickness of less than or equal to 10 mm.

9. Roof according to one of Claims 1 to 3, wherein the glass sheets have essentially the same dimensions and form a fully laminated assembly, the functional elements being accommodated between the glass sheets.

10. Roof according to Claim 9, wherein the first glass sheet has a thickness of 1 to 3 mm, the second glass sheet a thickness of 2 to 5 mm, the laminated assembly having a thickness of less than or equal to 10 mm.

11. Roof according to one of the preceding claims, wherein the interlayer sheet is formed from one or more sheets of thermoplastic materials of the group comprising: polyvinyl butyral (PVB), ethylene and vinyl acetate copolymers (EVA), polyurethanes (PU), polyvinyl chlorides (PVC).

12. Roof according to one of Claims 9 to 11, wherein during the course of assembly of the sheets, the functional elements are positioned in seatings formed by punching in a sheet used to form the interlayer, and the punched sheet is positioned between two other sheets also used to form the interlayer.

13. Roof according to one of Claims 9 to 11, wherein during the course of assembly, the functional elements are positioned in seatings formed by stamping in a sheet used to form the interlayer, with a second sheet also used to form the interlayer covering the first.

14. Roof according to one of the preceding claims, wherein the total thickness of the interlayer, possibly formed by several superposed sheets, is in the range of between 0.3 and 2 mm.

15. Roof according to one of the preceding claims, wherein the transmission of the transparent section is at least partially controlled by means of an enamelling following a motif formed by dots of very small dimensions arranged in a dose pattern, the enamelling being performed on the face of one of the glass sheets that is in contact with the interlayer.

16. Roof according to one of Claims 1 to 14, wherein the transmission of the transparent section is at least partially controlled by means of thin layers deposited on one of the glass sheets and on the face thereof that is in contact with the interlayer.

17. Roof according to Claim 16, wherein at least one of the layers is an athermal layer.

18. Roof according to Claim 17, wherein the layer is based on possibly doped tin oxide, indium and tin oxide, titanium or chromium nitride.

19. Roof according to Claim 16, wherein the layer is a silver-based reflective layer.

20. Roof according to one of the preceding claims, wherein the inside face of the first glass sheet has an enamelling, the design of which covers the surface except for the transparent section of the glazing and the cell seats.

Fig.1

Fig.2

Fig.3

## Fig.4

## Fig.5

## Fig.6

Fig.7

Fig.8